# EUROPÄISCHE PATENTSCHRIFT

(11) **EP 3 724 019 B1**
(45) Veröffentlichungstag und Bekanntmachung des Hinweises auf die Patenterteilung: **13.03.2024**
(21) Anmeldenummer: 17828695.1
(22) Anmeldetag: 15.12.2017
(51) Int. Cl.: B60K 35/00, B60K 37/00, B60K 37/06, H03K 17/96, B60Q 3/14, B60R 13/02

(54) **LINIENBELEUCHTUNG MIT INTEGRIERTEM BEDIENELEMENT**
LINE LIGHTING WITH INTEGRATED OPERATING ELEMENT
ÉCLAIRAGE LINÉAIRE MUNI D'UN ÉLÉMENT DE COMMANDE INTÉGRÉ

(43) Veröffentlichungstag der Anmeldung: 21.10.2020
(73) Patentinhaber: Lisa Dräxlmaier GmbH, 84137 Vilsbiburg (DE)
(72) Erfinder: ZAVIYALOV, Alexandr, 85591 Vaterstetten (DE); HERB, Andreas, 82131 Gauting (DE); WINKLBAUER, Manfred, 84034 Landshut (DE); FEINEIS, Martin, 84028 Landshut (DE)
(86) Internationale Anmeldenummer: PCT/EP2017/082990
(87) Internationale Veröffentlichungsnummer: WO 2019/114981

(56) Entgegenhaltungen:
- EP-A1- 3 241 702
- WO-A1-2015/090510
- US-A1- 2017 146 414
- US-A1- 2017 269 774

## Beschreibung

### Technisches Gebiet

Die vorliegende Erfindung betrifft ein Innenausstattungsteil für ein Kraftfahrzeug, insbesondere einen Personenkraftwagen, mit einer linienförmigen Beleuchtung, die gleichzeitig als Bedienelement für Fahrzeugfunktionen dienen kann.

### Stand der Technik

In modernen Kraftfahrzeugen, insbesondere Personenkraftwagen, befindet sich eine Vielzahl von Bedienelementen und Steuerelementen, um die vielseitigen Fahrzeugfunktionen des Fahrzeuges durch den Benutzer bedienen zu können. So können beispielsweise Schalter, Taster oder auch Drehregler zur Bedienung von Fahrzeugfunktionen Anwendung finden. Gleichzeitig ist es jedoch wünschenswert, dass ein Kraftfahrzeug ergonomisch und intuitiv bedienbar ist, so dass der Fahrzeuginsasse möglichst einfach die gewünschte Fahrzeugfunktion steuern kann. Somit muss die Anordnung der Bedienelemente möglichst intuitiv gewählt werden und darüber hinaus muss die Anzahl der Bedienelemente möglichst gering sein. Weiterhin ist es heute wünschenswert, dass sich die Bedienelemente in das Design des Innenraums des Kraftfahrzeugs einfügen. Dies stellt sich in der heutigen Zeit zunehmend schwerer dar, da mit jeder Fahrzeuggeneration neue Funktionen Anwendung finden.

Die US 2017/269774 A1 und die EP 3 241 702 A1 offenbaren ein Innenausstattungsteil für ein Kraftfahrzeug gemäß dem Oberbegriff des Patentanspruchs 1.

### Beschreibung der Erfindung

Es ist daher eine Aufgabe der Erfindung zumindest ein Bedienelement für Fahrzeugfunktionen bereitzustellen, dass sich leicht in den Innenraum eines Kraftfahrzeuges integrieren lässt und gleichzeitig einfach und intuitiv bedienen lässt.

Diese erfindungsgemäße Aufgabe wird durch den Gegenstand des unabhängigen Anspruchs gelöst. Vorteilhafte Weiterbildungen der Erfindung sind in den abhängigen Ansprüchen, der Beschreibung und den begleitenden Figuren angegeben.

Ein erfindungsgemäßes Innenausstattungsteil für ein Kraftfahrzeug umfasst zumindest eine Lichtquellenleiste mit zumindest einer Lichtquelle, eine zumindest teilweise transparente Zierleiste, die zumindest einen Teil der Sichtseite des Innenausstattungsteils ausbildet und einer zumindest teilweise transparenten, flächigen und berührungsempfindlichen Tasteinheit zur Bedienung zumindest einer Fahrzeugfunktion. Die Tasteinheit ist zumindest abschnittsweise flächig an der Zierleiste angeordnet. Die Lichtquellenleiste ist derart zur Zierleiste angeordnet, dass ein von der Lichtquelle abgegebenes Licht die Zierleiste und die Tasteinheit zumindest teilweise durchstrahlt.

Die Lichtquellenleiste kann beispielsweise mit einer länglichen Lichtquelle oder mehreren Lichtquellen, die nebeneinander angeordnet sind, ausgestattet sein. Beispielsweise kann die Lichtquellenleiste eine längliche Halbleiterplatine oder einen flexiblen Flachleiter umfassen, auf der Leuchtdioden angeordnet sind. Es ist von besonderem Vorteil, wenn die Lichtquellen ein Licht in verschiedenen Farben abgeben können, wie es beispielsweise mit Rot-Grün-Blau Leuchtdioden möglich ist. Die Zierleiste kann beispielsweise aus Glas oder einem Kunststoff bestehen. Sowohl die Zierleiste als auch die Lichtquellenleiste müssen nicht zwangsläufig einen linearen, geraden Verlauf aufweisen. Es ist ebenso möglich, dass die Zierleiste und/oder die Lichtquellenleiste Krümmungen und/oder Kurven aufweisen können und darüber hinaus in ihrer Breite über ihre Länge variieren können.

Unter der Tasteinheit kann ein Sensor verstanden werden, der eine Sensorfläche aufweist und bei einer Berührung bspw. durch einen Fahrzeuginsassen auf der Sensorfläche durch den Sensor eine Berührungsposition und/oder eine Bewegungsrichtung einer dynamischen Berührung auf der Sensorfläche ermittelbar ist. Die Tasteinheit kann ein piezoelektrisches oder kapazitives Sensorelement umfassen. Sowohl kapazitive als auch piezoelektrische Sensorelemente weisen den Vorteil auf, dass sie in besonders geringer Größe ausführbar sind, so dass der notwendige Bauraum durch die Tasteinheit nur unwesentlich erhöht wird. Gleichzeitig bietet insbesondere ein kapazitives Sensorelement den Vorteil, dass zur Erfassung einer Berührung eines Fahrzeuginsassen es nicht zwangsläufig zu einem direkten Kontakt mit der Anzeigefläche kommen muss. Es kann an dieser Stelle ausreichend sein, wenn der Fahrzeuginsasse beispielsweise seinen Finger in unmittelbarer Nähe zur Tasteinheit positioniert. Obwohl der Betrachter in diesem Fall die Tasteinheit selbst nicht berührt, kann die Berührung auf der Anzeigefläche entsprechend erfasst werden. Darüber hinaus kann die Tasteinheit entweder an einer der Lichtquellenleiste zugewandten Seite oder an einer der Lichtquellenleiste abgewandten Seite der Zierleiste angeordnet sein.

Die zumindest eine Lichtquelle der Lichtquellenleiste ist von einer Steuereinheit ansteuerbar. Die Steuereinheit kann beispielsweise direkt am Innenausstattungsteil angeordnet sein. Alternativ ist es jedoch ebenso möglich, dass zum Beispiel die Steuereinheit Teil der Bordelektronik des Fahrzeuges ist, und nicht in unmittelbarer Nähe zum Innenausstattungsteil positioniert ist.

Die Tasteinheit steht mit der Steuereinheit in Verbindung. Unter "in Verbindung stehen" kann in diesem Zusammenhang verstanden werden, dass eine von der Tasteinheit erfasste Berührung an die Steuereinheit kommuniziert wird. Dies kann beispielsweise über eine Kabelverbindung aber auch kabellos erfolgen.

Die Steuereinheit ist dabei dazu ausgebildet, die Lichtquelle derart anzusteuern, dass die Lichtquelle in Abhängigkeit davon, ob die Tasteinheit eine Berührung erfasst, in zumindest einem Schaltungszustand geändert wird, so dass durch das Licht der Lichtquelle angezeigt wird, dass die Tasteinheit eine Berührung erfasst hat. Die Steuereinheit erhält also bevorzugt ein Signal von der Tasteinheit, wenn die Tasteinheit eine Berührung erfasst. Dabei kann die Tasteinheit nicht nur der Steuereinheit übermitteln, dass eine Berührung erfasst wurde, es ist ebenso möglich, dass die Tasteinheit der Steuereinheit übermittelt, an welcher Position, die Tasteinheit Berührung erfasst hat. Ebenso ist es denkbar, dass die Tasteinheit der Steuereinheit übermittelt, in welcher Stärke die Berührung erfasst wurde. Abhängig von dieser Information steuert die Steuereinheit die Lichtquelle an und ändert entsprechend den Schaltungszustand der Lichtquelle.

Unter einem Schaltungszustand kann in diesem Zusammenhang beispielsweise ein Ein- und/oder Ausschalten der Lichtquelle, ein Ändern der Lichthelligkeit bzw. Lichtintensität und/oder ein Ändern der Lichtfarbe verstanden werden. Es ist in diesem Zusammenhang ebenso möglich, dass der Schaltungszustand sich dynamisch ändert. Beispielsweise kann die Steuereinheit die Lichtquelle mehrfach ein- und ausschalten, so dass ein Blinken erzeugt wird.

Da die Steuereinheit das Erfassen einer Berührung durch die Tasteinheit bei der Ansteuerung der Lichtquelle berücksichtigen kann, kann ein Innenausstattungsteil bereitgestellt werden, das im Fall einer erfassten Berührung durch die Tasteinheit über die Beleuchtung eine optische Rückmeldung für den Fahrzeuginsassen mithilfe der Steuereinheit und der Lichtquellenleiste bereitstellt. Der Fahrzeuginsasse wird also sofort durch ein Lichtsignal informiert, dass seine Eingabe von der Tasteinheit erfasst wurde und die gewünschte Änderung der Fahrzeugfunktion durchgeführt wird. Gleichzeitig kann die Steuereinheit Quellen jedoch auch derart ansteuern, dass eine Ambientebeleuchtung erzeugt wird, solange keine Berührung durch die Tasteinheit erfasst wird. Da sich der Schaltungszustand der Lichtquelle bei einer erfassten Berührung ändert, ist es für den Fahrzeuginsassen somit einfach möglich, die Ambientebeleuchtung von der Signalbeleuchtung zu unterscheiden. Auf diese Weise wird ein Bedienelement bereitgestellt, welches sich nahezu unsichtbar in das Design des Fahrzeuges integrieren lässt, und gleichzeitig vielfältige Bedienmöglichkeiten für verschiedenste Fahrzeugfunktionen ermöglicht.

Es kann von Vorteil sein, wenn die Steuereinheit dazu ausgebildet ist, die Lichtquelle derart anzusteuern, dass durch das Licht der Lichtquelle angezeigt wird, an welcher Position die Tasteinheit die Berührung erfasst hat. In diesem Zusammenhang ist es von Vorteil wenn die Tasteinheit der Steuereinheit übermittelt, an welcher Position die Tasteinheit die Berührung erfasst hat. Die Steuereinheit kann in diesem Zusammenhang die Lichtquelle zum Beispiel derart ansteuern, dass die Lichtquelle nur in dem Bereich, in dem die Berührung erfasst wurde, den Schaltungszustand ändert. Ebenso ist es möglich, dass beispielsweise durch ein spezielles Lauflicht oder Blinkermuster verdeutlicht wird, wo die Berührung erfasst wurde. Beispielsweise kann ausgehend von der erfassten Berührung sich ein Lauflicht von der Position wegbewegen.

Weiterhin kann es von Vorteil sein, dass die Steuereinheit dazu ausgestaltet ist die Lichtquelle derart anzusteuern, dass die Lichtquelle nach dem Einschalten eine definierte Zeitdauer den Schaltungszustand beibehält. Auf diese Weise ist sichergestellt, dass der Fahrzeuginsasse ausreichend Zeit hat, die Änderung des Schaltungszustands wahrzunehmen. Nach Verstreichen der Zeitdauer kann die Lichtquelle beispielsweise wieder auf den Zustand vor der Änderung des Schaltungszustands durch die Steuereinheit eingestellt werden.

Die Lichtquellenleiste kann eine Vielzahl von insbesondere punktförmigen Lichtquellen umfassen, die nebeneinander in zumindest einer Reihe angeordnet sind. Die punktförmigen Lichtquellen können beispielsweise durch Leuchtdioden ausgebildet sein. Es ist in diesem Zusammenhang von besonderem Vorteil, wenn jede Lichtquelle separat von der Steuereinheit angesteuert werden kann. Dies ist beispielsweise auf einfache Weise möglich, wenn es sich bei den Lichtquellen um einfarbige oder mehrfarbige Leuchtdioden handelt, die auf einer Halbleiterplatine oder einem flexiblen Flachleiter angeordnet sind, wobei die Lichtquellen über die Halbleiterplatine bzw. den flexiblen Flachleiter mit der Steuereinheit verbunden sein können.

In diesem Zusammenhang ist es von besonderem Vorteil, wenn sich die Reihe entlang der Zierleiste erstreckt. Es ist hierbei besonders bevorzugt, wenn die Reihe parallel zur Zierleiste verläuft. Durch die Verwendung von mehreren Lichtquellen, die in einer Reihe angeordnet sind, die sich entlang der Zierleiste erstrecken, lässt sich zum einen eine bessere optische Rückmeldung für den Fahrzeuginsassen realisieren, und zum anderen lässt sich ein individuelleres Ambientelicht erzeugen, sofern die Steuereinheit kein Signal von der Tasteinheit erhält.

Um das durch die Lichtquellenleiste erzeugte Licht an der Zierleiste hochwertiger und homogener wirken zu lassen, ist zwischen Lichtquellenleiste und Zierleiste eine Lichtleiterleiste angeordnet. Die Lichtleiterleiste ist zumindest teilweise transparent und kann zum Beispiel aus einem transparenten Kunststoff oder beispielsweise auch aus Glas ausgebildet sein. Die Lichtleiterleiste dient dabei in erster Linie dem Lichttransport, so dass das Licht der Lichtquellen möglichst verlustarm von der Lichtquellenleiste zur Zierleiste transportiert wird. Die Lichtleiterleiste kann als zusätzliches Bauteil zwischen Lichtquellenleiste und Zierleiste angeordnet werden. Es ist aber beispielsweise ebenso möglich, dass die Lichtleiterleiste einstückig mit der Zierleiste ausgebildet ist.

Erfindungsgemäß beinhaltet die Lichtleiterleiste zumindest abschnittsweise lichtstreuende Additive. Die lichtstreuenden Additive können beispielsweise Streupartikel sein, die im Material der Lichtleiterleiste angeordnet sind und eine Lichtstreuung begünstigen. Ebenso ist es aber auch denkbar, dass eine Lichtstreuung realisiert wird, indem beispielsweise die Oberflächen der Lichtleiterleiste strukturiert sind.

Die Lichtleiterleiste kann des Weiteren eine Einkoppelseite und eine Auskoppelsseite umfassen. Die Einkoppelseite der Lichtleiterleiste kann dabei der Lichtquellenseite zugewandt sein, wobei die Auskoppelseite der Zierleiste zugewandt sein kann. Es ist des Weiteren von Vorteil, wenn Einkoppelseite und Auskoppelseite einander gegenüberliegend angeordnet sind. Sowohl Einkoppelseite als auch Auskoppelseite können des Weiteren eine Strukturierung aufweisen, um das Einkoppeln bzw. Auskoppeln von Licht zu begünstigen.

Die Zierleiste kann darüber hinaus eine zumindest teilweise lichtdurchlässige Dekorschicht umfassen. Die Dekorschicht kann beispielsweise über einen transparenten Klebstoff auf der Zierleiste befestigt sein. Ebenso ist es möglich, dass die Dekorschicht die Zierleiste lediglich überspannt und an Bereichen, die an der Zierleiste angrenzen, befestigt ist. Die Dekorschicht kann sich des Weiteren auch über weitere Teile des Innenausstattungsteils erstrecken und muss nicht auf die Zierleiste beschränkt sein. Die Dekorschicht kann des Weiteren einschichtig oder auch mehrschichtig sein. Darüber hinaus kann die Dekorschicht haptikverbessernde Schichten, wie beispielsweise ein Abstandsgewirke, aufweisen.

Die Dekorschicht kann beispielsweise aus einem Textil, insbesondere einem Gewebe, einem Leder, einem lederähnlichen Material, aus einem Kunststoff oder einem Faserverbundwerkstoff ausgebildet sein. Die zumindest teilweise Lichtdurchlässigkeit der Dekorschicht kann dabei erzeugt werden, indem entweder die Dekorschicht selbst aus einem zumindest teilweise transparenten Material besteht oder indem eine Perforation in die Dekorschicht eingebracht ist.

Es kann darüber hinaus von Vorteil sein wenn die Zierleiste zumindest abschnittsweise aus einem transluzenten Material ausgebildet ist. In diesem Zusammenhang kann unter Transluzenz verstanden werden, dass ein Material nur für einen Teil des Lichtspektrums des sichtbaren Lichts durchlässig ist. Die Verwendung eines transluzenten Materials hat den Vorteil, dass bei ausgeschalteten Lichtquellen die Zierleiste nicht sofort als hinterleuchtbar sichtbar ist, da im unbeleuchteten Zustand die Lichtquellenleiste nicht sichtbar ist. Es ist an dieser Stelle daher von besonderem Vorteil, wenn das Material der Zierleiste derart transparent ist, dass die Zierleiste bei ausgeschalteter Lichtquelle blickdicht ist.

Erfindungsgemäß umfasst die Tasteinheit eine zumindest teilweise transparente Folie. Da insbesondere piezoelektrische und kapazitive Sensorelemente nahezu transparent ausgeführt werden können, ist es an dieser Stelle besonders vorteilhaft, wenn als Trägermaterial dieser Sensorelemente eine, insbesondere transparente Folie dient und die Tasteinheit eine solche transparente Folie umfasst. Zum einen ist die Handhabbarkeit des Tastelements somit deutlich vereinfacht und zum anderen ist das von der Lichtquelle abgegebene Licht durch die Tasteinheit nicht beeinflusst oder verfälscht.

Es ist ebenso denkbar, dass die Tasteinheit eine transluzente Beschichtung aufweist. Die Zierleiste kann in diesem Zusammenhang entweder transluzent oder auch transparent sein. Es ist jedoch bevorzugt, dass die Zierleiste im Falle, dass die Tasteinheit eine transluzente Beschichtung aufweist, transparent ausgeführt ist. Die Beschichtung kann dabei zum Beispiel als Folie auf die Tasteinheit aufgebracht sein und besteht besonders bevorzugt aus einem Kunststoff.

Es ist des Weiteren von Vorteil, wenn die punktförmigen Lichtquellen mehrerer parallel zueinander angeordnete Reihen ausbilden. Die mehreren Reihen können dabei entweder parallel zur Zierleiste oder im Winkel zur Zierleiste angeordnet sein. Ebenso ist es möglich dass ein Teil der Reihen parallel zur Zierleiste und ein Teil der Reihen im Winkel zur Zierleiste angeordnet sind.

Des Weiteren ist es von Vorteil, wenn Lichtquellen im gleich bleibenden Abstand zur Zierleiste angeordnet sind. Auf diese Weise bleibt sichergestellt, dass das wahrgenommene Licht vom Fahrzeuginsassen bei gleicher Ansteuerung an verschiedenen Stellen für den Fahrzeuginsassen gleich wirkt, was die Ansteuerung der Lichtquelle durch die Steuereinheit vereinfacht.

Die Lichtquellenleiste kann in einem Gehäuse angeordnet sein, wobei die Zierleiste das Gehäuse an zumindest einer Seite verschließen kann. Das Gehäuse kann ebenfalls als Leiste ausgebildet sein und beispielsweise einen U-förmigen Querschnitt aufweisen. In diesem Fall kann die Lichtquellenleiste am Grund der Form angeordnet sein, wobei die durch die U-Form gebildete offene Seite durch eine Zierleiste verschlossen wird.

### Kurze Figurenbeschreibung

Darüber hinaus sind weitere Vorteile und Merkmale der vorliegenden Erfindung aus der folgenden Beschreibung bevorzugter Ausführungsformen ersichtlich. Die dort und oben beschriebenen Merkmale können alleinstehend oder in Kombination umgesetzt werden, insofern sich die Merkmale nicht widersprechen. Die folgende Beschreibung bevorzugter Ausführungsformen erfolgt dabei unter Bezugnahme auf die begleitenden Zeichnungen. Dabei zeigen:
- Figur 1: eine Explosionsdarstellung einer ersten Ausführungsform eines erfindungsgemäßen Innenausstattungsteils, und
- Figur 2: eine perspektivische Darstellung einer zweiten Ausführungsform des erfindungsgemäßen Innenausstattungsteils.

Die Figuren sind lediglich schematische Darstellungen und dienen nur der Erläuterung der Erfindung. Gleiche oder gleichwirkende Elemente sind durchgängig mit den gleichen Bezugszeichen versehen.

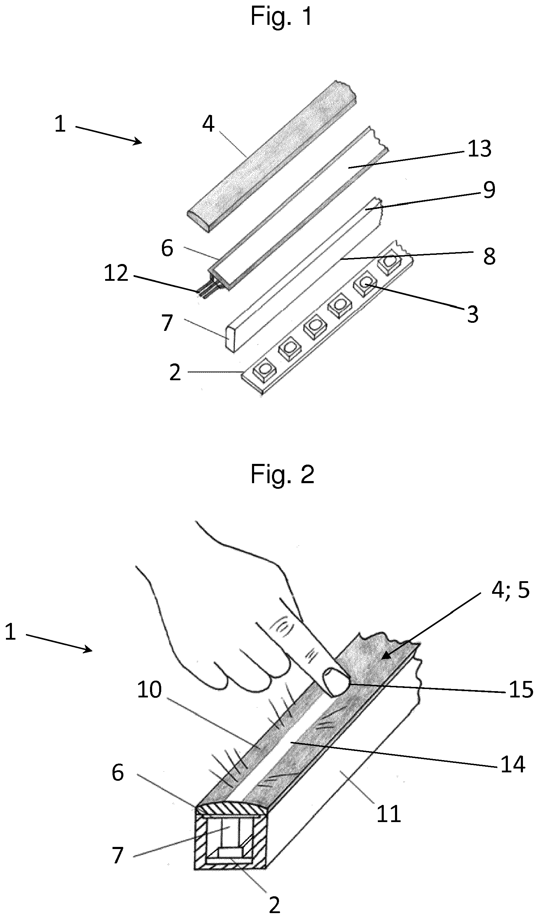

Figur 1 zeigt eine Explosionsdarstellung einer ersten Ausführungsform eines erfindungsgemäßen Innenausstattungsteils 1. Das Innenausstattungsteil 1 umfasst eine Lichtquellenleiste 2, die aus einer Halbleiterplatine besteht, auf der mehrfarbige Leuchtdioden angeordnet sind. Die Leuchtdioden sind über die Halbleiterplatine mit einer nicht gezeigten Steuereinheit derart verbunden, dass jede Leuchtdiode unabhängig von der Steuereinheit angesteuert werden kann. Auf der Lichtquellenleiste 2 ist eine Lichtleiterleiste 7 angeordnet, die im vorliegenden Ausführungsbeispiel aus transparentem Polycarbonat ausgebildet ist. Die Lichtleiterleiste 7 besitzt eine Einkoppelseite 8, die der Lichtquellenleiste 2 zugewandt ist und im Wesentlichen dazu dient, dass von der Lichtquellenleiste 2 abgegebenes Licht 14 in die Lichtleiterleiste 7 eingekoppelt wird. Der Einkoppelseite 8 gegenüberliegend besitzt die Lichtleiterleiste 7 eine Auskoppelseite 9, an der das in die Lichtleiterleiste 7 eingekoppelte Licht 14 wieder ausgekoppelt wird. Im vorliegenden Ausführungsbeispiel grenzt die Auskoppelseite 9 an eine flächige Tasteinheit 6 an, die aus einer transparenten Folie besteht, die kapazitiv wirkende Schichten umfasst, die über elektrische Anschlüsse 12 mit einer nicht gezeigten Bordelektronik des Fahrzeuges und der nicht gezeigten Steuerelektronik verbunden ist.

Die Tasteinheit 6 besitzt des Weiteren eine Beschichtung 13 aus einem transluzenten Material. Im vorliegenden Ausführungsbeispiel handelt es sich bei der Beschichtung 13 um eine transluzente Kunststofffolie, die auf die Tasteinheit 6 auflaminiert ist. Alternativ kann die Beschichtung 13 auch durch Hinterspritzung an der Tasteinheit 6 angebracht sein. Das Innenausstattungsteil 1 umfasst darüber hinaus eine Zierleiste 4, die an der Seite der Tasteinheit 6, auf der die Beschichtung 13 aufgebracht ist, angeordnet ist. Die Zierleiste 4 besteht im vorliegenden Ausführungsbeispiel aus einem transparenten Polymethmethylacrylat, das mit Hilfe eines nicht gezeigten transparenten Klebstoffes mit der Tasteinheit 6 verbunden wird. Alternativ kann die Zierleiste 4 jedoch auch aus Polycarbonat bestehen. Anstelle eines Klebstoffes kann die Zierleiste 4 auch durch Hinterspritzen mit der Tasteinheit 6 verbunden sein.

Figur 2 zeigt eine weitere Ausführungsform des erfindungsgemäßen Innenausstattungsteils 1 in einer perspektivischen Ansicht. Im vorliegenden Ausführungsbeispiel sind die Lichtquellenleiste 2 und die Lichtleiterleiste 7 in einem Gehäuse 11 mit U-förmigem Querschnitt angeordnet. Dabei ist die Lichtquellenleiste 2 an dem Gehäuse 11 befestigt. Die Lichtleiterleiste 7 ist dabei lösbar auf die Lichtquellenleiste 2 aufgesteckt. Das U-förmige Gehäuse 11 wird an seiner offenen Seite von der Zierleiste 4 verschlossen. Die Zierleiste 4 ist hierzu an dem Gehäuse 11 angeklebt. Im vorliegenden Ausführungsbeispiel ist auf der Zierleiste 4 eine Dekorschicht 10 aus einem grobmaschigen Textil angeordnet. Die Zierleiste 4 bildet gleichzeitig eine Sichtseite 5 des Innenausstattungsteils 1 aus. Unter Sichtseite 5 kann in diesem Zusammenhang eine Seite verstanden werden, die im Einbauzustand des Innenausstattungsteils 1 vom Fahrzeuginsassen wahrgenommen werden kann. Des Weiteren ist an der Lichtleiterleiste 7 zugewandten Seite der Zierleiste 4 die flächige Tasteinheit 6 angeordnet. Die Lichtleiterleiste 7 setzt dabei auf die Tasteinheit 6 auf, so dass kein Luftspalt zwischen Lichtleiterleiste 7 und Tasteinheit 6 ausgebildet wird. Durch das Gehäuse 11 wird eine in sich geschlossene Baugruppe ausgebildet, die beispielsweise an weitere Innenausstattungsteile, wie zum Beispiel einer Türverkleidung, einen Dachhimmel, einer Instrumententafel oder einer Mittelkonsole angebracht werden kann.

Wie in Figur 2 ebenfalls gezeigt ist, kann das erfindungsgemäße Innenausstattungsteil 1 verwendet werden, um Fahrzeugfunktionen, wie zum Beispiel das Öffnen und Schließen einer Seitenscheibe oder des Dachhimmels oder zur Verstellung der Sitzposition, einzustellen. Im vorliegenden Ausführungsbeispiel muss ein Fahrzeuginsasse die Zierleiste 4 berühren. Der Fahrzeuginsasse kann dabei entweder nur einen speziellen Punkt auf der Zierleiste 4 berühren oder, wie in Figur 2 gezeigt wird, entlang der Zierleiste 4 mit seinem Finger wischen. Die Berührung 15 wird durch die Tasteinheit 6 erfasst. Die Tasteinheit 6 erfasst dabei die Berührung 15, indem sich die Kapazität der Tasteinheit 6 ändert, was entsprechend von der nicht gezeigten Steuereinheit oder der nicht gezeigten Bordelektronik des nicht gezeigten Fahrzeuges erfasst werden kann. Die erfasste Berührung 15 kann dann von der Bordelektronik ausgewertet werden, so dass die gewünschte Fahrzeugfunktion entsprechend von der Bordelektronik angesteuert werden kann. Da die nicht gezeigte Steuereinheit das Signal der Tasteinheit 6 ebenfalls erfasst, steuert die Steuereinheit die Lichtquellen 3 der Lichtquellenleiste 2 im vorliegenden Ausführungsbeispiel derart an, dass die Lichtquellenleiste 2 überall dort aufleuchtet, wo die Tasteinheit 6 eine Berührung 15 detektiert hat. Da der Fahrzeuginsasse im vorliegenden Ausführungsbeispiel über die Zierleiste 4 wischt, wird von der Lichtquellenleiste 2 eine entsprechende Lichtlinie erzeugt. Das Licht 14 der Lichtquellenleiste 2 durchstrahlt dabei die Lichtleiterleiste 7, die Tasteinheit 6 und die Zierleiste 4, so dass für den Fahrzeuginsassen eine Lichtlinie auf der Zierleiste 4 sichtbar wird. Der Fahrzeuginsasse kann somit erkennen, dass seine Berührung 15 von der Tasteinheit 6 erfasst wurde. Im vorliegenden Ausführungsbeispiel ändert die Steuereinheit die Ansteuerung der Lichtquellenleiste 2 nach 6 Sekunden derart, dass über die gesamte Lichtquellenleiste 2 ein homogenes Linienlicht erzeugt wird, das als Ambientebeleuchtung dient.

### BEZUGSZEICHENLISTE

- 1: Innenausstattungsteil
- 2: Lichtquellenleiste
- 3: Lichtquelle
- 4: Zierleiste
- 5: Sichtseite
- 6: Tasteinheit
- 7: Lichtleiterleiste
- 8: Einkoppelseite
- 9: Auskoppelseite
- 10: Dekorschicht
- 11: Gehäuse
- 12: elektrische Anschlüsse
- 13: Beschichtung
- 14: Licht
- 15: Berührung

## Patentansprüche

1. Innenausstattungsteil (1) für ein Kraftfahrzeug, mit:
einer Lichtquellenleiste (2), die zumindest eine Lichtquelle (3) umfasst,
einer zumindest teilweise transparenten Zierleiste (4), die zumindest einen Teil einer Sichtseite (5) des Innenausstattungsteils (1) ausbildet,
einer zumindest teilweise transparenten, flächigen und berührungsempfindlichen Tasteinheit (6) zur Bedienung zumindest einer Fahrzeugfunktion, die zumindest abschnittsweise flächig an der Zierleiste (4) angeordnet ist, und
die Lichtquellenleiste (2) derart zur Zierleiste (4) angeordnet ist, dass ein von der Lichtquelle (3) abgegebenes Licht (14) die Zierleiste (4) und die Tasteinheit (6) zumindest teilweise durchstrahlt,
die Lichtquelle (3) von einer Steuereinheit ansteuerbar ist,
die Tasteinheit (6) mit der Steuereinheit in Verbindung steht und die Steuereinheit dazu ausgebildet ist, die Lichtquelle (3) derart anzusteuern, dass die Lichtquelle (3) in Abhängigkeit davon, ob die Tasteinheit (6) eine Berührung (15) erfasst, in zumindest einem Schaltungszustand geändert wird, so dass durch das Licht (14) der Lichtquelle (3) angezeigt wird, dass die Tasteinheit (6) eine Berührung (15) erfasst hat, wobei zwischen Zierleiste (4) und Lichtquellenleiste (2) eine zumindest teilweise transparente Lichtleiterleiste (7) angeordnet ist. **dadurch gekennzeichnet,**
**dass** die Lichtleiterleiste (7) zumindest abschnittsweise lichtstreuende Additive beinhaltet und die Tasteinheit (6) eine zumindest teilweise transparente Folie umfasst.

2. Innenausstattungsteil (1) nach dem vorhergehenden Anspruch, **dadurch gekennzeichnet, dass** die Steuereinheit dazu ausgebildet ist, die Lichtquelle (3) derart anzusteuern, dass durch das Licht (14) der Lichtquelle (3) angezeigt wird, an welcher Position die Tasteinheit (6) die Berührung (15) erfasst hat.

3. Innenausstattungsteil (1) nach einem der vorhergehenden Ansprüche, **dadurch gekennzeichnet, dass** die Steuereinheit ausgestaltet ist, die Lichtquelle (3) derart anzusteuern, dass die Lichtquelle (3) nach dem Einschalten eine definierte Zeitdauer den Schaltungszustand beibehält.

4. Innenausstattungsteil (1) nach einem der vorhergehenden Ansprüche, **dadurch gekennzeichnet, dass** die Lichtquellenleiste (2) eine Vielzahl von, insbesondere punktförmigen, Lichtquellen (3) umfasst, die nebeneinander in zumindest einer Reihe angeordnet sind.

5. Innenausstattungsteil (1) nach dem vorhergehenden Anspruch, **dadurch gekennzeichnet, dass** sich die Reihe entlang der Zierleiste (4) erstreckt.

6. Innenausstattungsteil (1) nach einem der der vorhergehenden Ansprüchen, **dadurch gekennzeichnet, dass** die Lichtleiterleiste (7) eine Einkoppelseite (8) und eine Auskoppelseite (9) umfasst, wobei die Einkoppelseite (8) der Lichtquellenleiste (2) und die Auskoppelseite (9) der Zierleiste (4) zugewandt sind.

7. Innenausstattungsteil (1) nach einem der vorhergehenden Ansprüche, **dadurch gekennzeichnet, dass** die Zierleiste (4) eine zumindest teilweise lichtdurchlässige Dekorschicht (10) umfasst.

8. Innenausstattungsteil (1) nach dem vorhergehenden Anspruch, **dadurch gekennzeichnet, dass** die Dekorschicht (10) zumindest abschnittsweise ein Textil, insbesondere ein Gewebe, oder eine perforierte Lederschicht umfasst.

9. Innenausstattungsteil (1) nach einem der vorhergehenden Ansprüche, **dadurch gekennzeichnet, dass** die Zierleiste (4) zumindest abschnittsweise aus einem transluzenten Material ausgebildet ist.

10. Innenausstattungsteil (1) nach einem der vorhergehenden Ansprüche, **dadurch gekennzeichnet, dass** die Tasteinheit (6) eine transluzente Beschichtung (13) aufweist.

11. Innenausstattungsteil (1) nach einem der vorhergehenden Ansprüche, **dadurch gekennzeichnet, dass** die punktförmigen Lichtquellen (3) mehrere parallel zueinander angeordnete Reihen ausbilden.

12. Innenausstattungsteil (1) nach einem der vorhergehenden Ansprüche, **dadurch gekennzeichnet, dass** die Lichtquellen (3) im, bevorzugt gleichbleibenden, Abstand zur Zierleiste (4) angeordnet sind.

13. Innenausstattungsteil (1) nach einem der vorhergehenden Ansprüche, **dadurch gekennzeichnet, dass** die Lichtquellenleiste (2) in einem Gehäuse (11) angeordnet ist und die Zierleiste (4) das Gehäuse (11) an zumindest einer Seite verschließt.

14. Innenausstattungsteil (1) nach einem der vorhergehenden Ansprüche, **dadurch gekennzeichnet, dass** die Steuereinheit ausgestaltet ist, die zumindest eine Lichtquelle (3) unabhängig von einer Berührung (15) an der Tasteinheit (6), zur Erzeugung eines Ambientelichts oder Signallichts anzusteuern.

## Claims

1. Interior part (1) for a motor vehicle, with:
a light source strip (2) comprising at least one light source (3),
an at least partially transparent decorative strip (4), which forms at least part of a visible side (5) of the interior part (1),
an at least partially transparent, flat and touch-sensitive button unit (6) for operating at least one vehicle function, which is arranged at least in sections flat on the decorative strip (4), and
the light source strip (2) is arranged relative to the decorative strip (4) in such a way that a light (14) emitted by the light source (3) at least partially radiates through the decorative strip (4) and the button unit (6),
the light source (3) can be controlled by a control unit,
the button unit (6) is connected to the control unit and the control unit is designed to control the light source (3) in such a way that the light source (3) is changed in at least one switching state depending on whether the button unit (6) detects a touch (15), so that the light (14) of the light source (3) indicates that the button unit (6) has detected a touch (15), an at least partially transparent light guide strip (7) being arranged between the decorative strip (4) and the light source strip (2). **characterized in that**
**in that** the light guide strip (7) at least partially contains light-diffusing additives and the button unit (6) comprises an at least partially transparent film.

2. Interior part (1) according to the preceding claim, **characterized in that** the control unit is designed to control the light source (3) in such a way that the light (14) of the light source (3) indicates the position at which the button unit (6) has detected the touch (15).

3. Interior part (1) according to one of the preceding claims, **characterized in that** the control unit is designed to control the light source (3) in such a way that the light source (3) maintains the switching state for a defined period of time after being switched on.

4. Interior part (1) according to one of the preceding claims, **characterized in that** the light source strip (2) comprises a plurality of, in particular punctiform, light sources (3) which are arranged next to one another in at least one row.

5. Interior part (1) according to one of the preceding claim, **characterized in that** the row extends along the decorative strip (4).

6. Interior part (1) according to one of the preceding claims, **characterized in that** the light guide strip (7) comprises a coupling-in side (8) and a coupling-out side (9), the coupling-in side (8) facing the light source strip (2) and the coupling-out side (9) facing the decorative strip (4).

7. Interior part (1) according to one of the preceding claims, **characterized in that** the decorative strip (4) comprises an at least partially translucent decorative layer (10).

8. Interior part (1) according to one of the preceding claim, **characterized in that** the decorative layer (10) comprises at least sectionally a textile, in particular a fabric, or a perforated leather layer.

9. Interior part (1) according to one of the preceding claims, **characterized in that** the decorative strip (4) has at least in sections a translucent material.

10. Interior part (1) according to one of the preceding claims, **characterized in that** the button unit (6) has a translucent coating (13).

11. Interior part (1) according to one of the preceding claims, **characterized in that** the punctiform light sources (3) form a plurality of rows arranged parallel to one another.

12. Interior part (1) according to one of the preceding claims, **characterized in that** the light sources (3) are arranged at a, preferably constant, distance from the decorative strip (4).

13. Interior part (1) according to one of the preceding claims, **characterized in that** the light source strip (2) is arranged in a casing (11) and the decorative strip (4) closes the casing (11) on at least one side.

14. Interior part (1) according to one of the preceding claims, **characterized in that** the control unit is designed to control the at least one light source (3) independently of a touch (15) on the button unit (6) in order to generate an ambient light or signal light.

## Revendications

1. Pièce d'équipement intérieur (1) pour un véhicule automobile, comprenant :
une barrette de sources lumineuses (2) qui comprend au moins une source lumineuse (3),
une baguette décorative (4) au moins partiellement transparente, qui forme au moins une partie d'une face visible (5) de la pièce d'équipement intérieur (1),
d'une unité de touches (6) au moins partiellement transparente, plate et sensible au toucher pour la commande d'au moins une fonction du véhicule, qui est disposée au moins par sections sur la surface de la baguette décorative (4), et
la baguette de source lumineuse (2) est disposée par rapport à la baguette décorative (4) de telle sorte qu'une lumière (14) émise par la source lumineuse (3) traverse au moins partiellement la baguette décorative (4) et l'unité de touche (6),
la source lumineuse (3) peut être commandée par une unité de commande,
l'unité de touche (6) est en liaison avec l'unité de commande et l'unité de commande est conçue pour commander la source lumineuse (3) de telle sorte que la source lumineuse (3) est modifiée dans au moins un état de commutation en fonction du fait que l'unité de touche (6) détecte ou non un contact (15), de sorte que la lumière (14) de la source lumineuse (3) indique que l'unité de touche (6) a détecté un contact (15), une baguette de guidage de lumière (7) au moins partiellement transparente étant disposée entre la baguette décorative (4) et la baguette de source lumineuse (2). **caractérisé en ce que**
que la baguette de guidage de lumière (7) contient au moins par sections des additifs diffusant la lumière et que l'unité de palpage (6) comprend une feuille au moins partiellement transparente.

2. Pièce d'équipement intérieur (1) selon la revendication précédente, **caractérisée en ce que** l'unité de commande est adaptée pour commander la source de lumière (3) de telle sorte que la lumière (14) de la source de lumière (3) indique à quelle position l'unité de touche (6) a détecté le contact (15).

3. Elément d'aménagement intérieur (1) selon l'une des revendications précédentes, **caractérisé en ce que** l'unité de commande est conçue pour commander la source lumineuse (3) de telle sorte que la source lumineuse (3) conserve l'état de commutation pendant une durée définie après l'allumage.

4. Pièce d'équipement intérieur (1) selon l'une des revendications précédentes, **caractérisée en ce que** la rampe de sources lumineuses (2) comprend une pluralité de sources lumineuses (3), notamment ponctuelles, disposées les unes à côté des autres sur au moins une rangée.

5. Pièce d'équipement intérieur (1) selon la revendication précédente, **caractérisée en ce que** la rangée s'étend le long de la moulure (4).

6. Pièce d'équipement intérieur (1) selon l'une des revendications précédentes, **caractérisée en ce que** la baguette de guidage de lumière (7) comprend un côté d'accouplement (8) et un côté de désaccouplement (9), le côté d'accouplement (8) étant tourné vers la baguette de source lumineuse (2) et le côté de désaccouplement (9) étant tourné vers la baguette décorative (4).

7. Pièce d'équipement intérieur (1) selon l'une des revendications précédentes, **caractérisée en ce que** la moulure (4) comprend une couche décorative (10) au moins partiellement translucide.

8. Pièce d'équipement intérieur (1) selon la revendication précédente, **caractérisée en ce que** la couche décorative (10) comprend au moins par sections un textile, en particulier un tissu, ou une couche de cuir perforée.

9. Pièce d'équipement intérieur (1) selon l'une des revendications précédentes, **caractérisée en ce que** la baguette décorative (4) est réalisée au moins par sections dans un matériau translucide.

10. Pièce d'équipement intérieur (1) selon l'une des revendications précédentes, **caractérisée en ce que** l'unité de touche (6) présente un revêtement translucide (13).

11. Pièce d'équipement intérieur (1) selon l'une des revendications précédentes, **caractérisée en ce que** les sources lumineuses ponctuelles (3) forment plusieurs rangées disposées parallèlement les unes aux autres.

12. Pièce d'équipement intérieur (1) selon l'une des revendications précédentes, **caractérisée en ce que** les sources lumineuses (3) sont disposées à une distance, de préférence constante, de la baguette décorative (4).

13. Pièce d'équipement intérieur (1) selon l'une des revendications précédentes, **caractérisée en ce que** la rampe de sources lumineuses (2) est disposée dans un boîtier (11) et **en ce que** la moulure (4) ferme le boîtier (11) sur au moins un côté.

14. Elément d'équipement intérieur (1) selon l'une des revendications précédentes, **caractérisé en ce que** l'unité de commande est conçue pour commander l'au moins une source de lumière (3) indépendamment d'un contact (15) sur l'unité de touches (6), pour produire une lumière d'ambiance ou une lumière de signalisation.
